# EUROPÄISCHE PATENTANMELDUNG

(11) **EP 2 426 704 A1**
(43) Veröffentlichungstag der Anmeldung: **07.03.2012**
(21) Anmeldenummer: 11007070.3
(22) Anmeldetag: 31.08.2011
(51) Int. Cl.: H01L 21/285

(54) **Verfahren zur Herstellung einer Metallstruktur auf einer Oberfläche eines Halbleitersubstrates**

(30) Priorität: 03.09.2010 DE 102010044350
(71) Anmelder: Fraunhofer-Gesellschaft zur Förderung der angewandten Forschung e.V., 80686 München (DE)
(72) Erfinder: Reinwand, Dirk, 79110 Freiburg (DE); Biro, Daniel, 79106 Freiburg (DE); Specht, Jan, 79106 Freiburg (DE); Preu, Ralf, 79117 Freiburg (DE); Stüwe, David, 79106 Freiburg (DE)
(74) Vertreter: Lemcke, Brommer & Partner

(57) **Zusammenfassung**

Die Erfindung betrifft ein Verfahren zur Herstellung einer Metallstruktur (6) auf einer Oberfläche eines Halbleitersubstrates (1), folgende Schritte umfassend:
A
Aufbringen einer Strukturierungsschicht (5), welche mittels einer Hot-Melt-Tinte oder eines Fotolackes erzeugt wird, auf die Oberfläche der Halbeiterstruktur oder auf eine oder mehrere die Oberfläche bedeckende Zwischenschichten,
B
Aufbringen einer Metallschicht (6) und
C
Entfernen der Strukturierungsschicht (5),

wobei in einem Lift-Off-Verfahren Schritt B nach Schritt A und Schritt C nach Schritt B ausgeführt wird, derart, dass die Strukturierungsschicht im Wesentlichen von der Metallschicht bedeckt ist und zumindest in den Bereichen, in denen die Metallschicht die Strukturierungsschicht bedeckt, bei Ausführung von Schritt C die Metallschicht abgelöst wird. Die Erfindung ist dadurch gekennzeichnet, dass in Schritt B die Metallschicht mittels Sputterdeposition ("Sputtern") aufgebracht wird.

## Beschreibung

### Beschreibung

Die Erfindung betrifft ein Verfahren zur Herstellung einer Metallstruktur auf einer Oberfläche eines Halbleitersubstrates gemäß Oberbegriff des Anspruchs 1.

Zur Herstellung einer Metallstruktur auf eine Oberfläche eines Halbleitersubstrates sind Verfahren bekannt, bei denen in einem Schritt A eine Strukturierungsschicht aufgebracht wird, in einem Schritt B eine Metallschicht aufgebracht wird und in einem Schritt C die Strukturierungsschicht entfernt wird.

Je nach Abfolge der Schritte A bis C unterscheidet man zwischen Maskierungsverfahren und Lift-Off-Verfahren:
Bei einem Maskierungsverfahren wird zunächst die Metallschicht aufgebracht und die Strukturierungsschicht danach lediglich in den Bereichen aufgebracht, in denen die Metallschicht auf dem Halbleitersubstrat verbleiben soll. An den Stellen, an denen sich keine Strukturierungsschicht befindet, wird die Metallschicht entfernt, beispielsweise mittels einer ätzenden Substanz, welche die Metallschicht, nicht jedoch die Strukturierungsschicht abätzt.

Anschließend wird die Strukturierungsschicht entfernt, so dass lediglich in den gewünschten Bereichen die Metallschicht verbleibt und somit die Metallstruktur erzeugt wurde.

In einem Lift-Off-Verfahren wird zunächst die Strukturierungsschicht in den Bereichen der Oberfläche des Halbleitersubstrates aufgebracht, in denen keine Metallstruktur erwünscht ist und danach wird die Metallschicht im Wesentlichen ganzflächig aufgebracht. Wird nun wiederum danach in Schritt C die Strukturierungsschicht abgelöst, so wird die Metallschicht zusammen mit der Strukturierungsschicht abgelöst, jedoch nur in den Bereichen, in denen sich Strukturierungsschicht auf der Oberfläche des Halbleitersubstrates befand, so dass in den übrigen Bereichen die Metallschicht auf der Oberfläche verbleibt und somit die Metallstruktur erzeugt wurde.

Zum Aufbringen der Strukturierungsschicht sind unterschiedliche Verfahren bekannt:
Aus der Chipherstellung sind Fotolithografieverfahren bekannt, bei denen mittels Aufbringen eines fotosensitiven Lackes, Belichten über eine Belichtungsmaske und Entwickeln und selektives Entfernen des belichteten oder des unbelichteten Lackes Strukturierungsschichten mit hoher Präzision und mit feinen Strukturen erzeugt werden können. Nachteilig an der Fotolithografie ist, dass das Verfahren aufwendig und damit kostenintensiv ist und nicht in einem In-Line-Prozess durchgeführt werden kann.

Ebenso ist es bekannt, Strukturierungsschichten mittels eines Siebdruckverfahrens zu erzeugen, bei dem über ein Sieb, welches die Struktur vorgibt, Druckpaste mittels eines Druckrakels durch das Sieb hindurch auf das Halbleitersubstrat aufgetragen wird. Diese Methode ist wesentlich kostengünstiger, weist jedoch den Nachteil auf, dass keine feinen Strukturen mittels der Siebdrucktechnik herstellbar sind. Weiterhin ist mit herkömmlichen Verfahren eine Kombination eines Lift-Off- und Siebdruckverfahrens für die Erzeugung einer Metallstruktur nicht oder nur mit hohem technischen und damit kostenintensiven Aufwand möglich.

Weiterhin ist es aus DE 10 2008 029 107 A1 bekannt, in Verfahrensschritt A die Strukturierungsschicht mittels einer Hot-Melt-Tinte zu erzeugen. Die Verwendung einer Hot-Melt-Tinte zur Erzeugung der Strukturierungsschicht weist den Vorteil auf, dass beispielsweise gegenüber Fotolithografieverfahren eine technisch unaufwändigere und damit kostengünstigere Methode vorliegt. Die Verwendung einer Hot-Melt-Tinte ist somit äußerst vielversprechend, um das genannte Verfahren in industrielle Fertigungsprozesse, insbesondere zur Herstellung von Solarzellen zu integrieren und eine Senkung der Herstellungskosten zu erzielen.

Der vorliegenden Erfindung liegt die Aufgabe zugrunde, das vorgenannte Verfahren zur Herstellung einer Metallstruktur auf einer Oberfläche eines Halbleitersubstrates in der Ausführung als Lift-Off-Verfahren und unter Verwendung einer Strukturierungsschicht weiterzubilden, um eine Erzeugung feinerer Metallstrukturen und/oder eine weitere Kostenreduzierung bei dem Herstellungsprozess zu ermöglichen.

Gelöst ist diese Aufgabe durch ein Verfahren gemäß Anspruch 1, vorteilhafte Ausgestaltungen finden sich in den Ansprüchen 2 bis 15.

Das erfindungsgemäße Verfahren zur Herstellung einer Metallstruktur auf einer Oberfläche eines Halbleitersubstrates umfasst somit folgende Verfahrensschritte: In einem Verfahrensschritt A wird eine Strukturierungsschicht aufgebracht, welche mittels einer Hot-Melt-Tinte oder eines Fotolackes erzeugt wird. Die Strukturierungsschicht wird auf die Oberfläche der Halbleiterstruktur oder auf eine oder mehrere die Oberfläche bedeckenden Zwischenschichten aufgebracht.

In einem Verfahrensschritt B wird eine Metallschicht aufgebracht und in einem Verfahrensschritt C wird die Strukturierungsschicht entfernt.

Das erfindungsgemäße Verfahren ist als Lift-Off-Verfahren ausgebildet, bei dem Schritt B nach Schritt A und Schritt C nach Schritt B ausgeführt wird. Die Ausführung erfolgt derart, dass die Strukturierungsschicht im Wesentlichen von der Metallschicht bedeckt ist und zumindest in den Bereichen, in denen die Metallschicht die Strukturierungsschicht bedeckt, bei Ausführung von Schritt C die Metallschicht abgelöst wird.

Hierbei liegt es sowohl im Rahmen der Erfindung, dass die genannten Schritte unmittelbar aufeinander folgen. Ebenso ist es jedoch auch möglich, zwischen den genannten Schritten A bis C im Rahmen der Erfindung weitere Zwischenschritte einzufügen.

Wesentlich ist, dass in Schritt B die Metallschicht mittels Sputterdeposition (im Folgenden "Sputtern") aufgebracht wird.

Das Aufbringen einer Metallschicht mittels Sputtern ist an sich bekannt und beispielsweise in von Brian Chapman (Chapman, B.: "Glow discharge processes - sputtering and plasma etching". John Wiley & Sons. New York. 1980) beschrieben. Gegenüber anderen Methoden zum Aufbringen einer Metallschicht, wie beispielsweise Aufdampfen oder Aufbringen einer Metallpaste in einem Druckverfahren (z. B. Siebdruckverfahren) weist Sputtern folgende Vorteile auf: Gegenüber dem Siebdruckverfahren hat sich gezeigt, dass gesputterte Schichten mit weitaus feineren Strukturen erzeugt werden können; dies bedeutet eine verringerte Verschattung der Oberfläche und einer daraus folgenden größeren Sonneneinstrahlung. Darüber hinaus ist der Übergangswiderstand zwischen Metall und Halbleitermaterial bei gesputterten Kontakten geringer, als bei siebgedruckten Kontakten. Im Vergleich zu aufgedampften Kontakten ergibt sich ein nicht unbedeutender Vorteil aufgrund der Möglichkeit die metallischen Schichten bei wesentlich geringeren Temperaturen abzuscheiden.

Bei dem erfindungsgemäßen Verfahren wird somit erstmals in einem Lift-Off-Verfahren die Erzeugung der Strukturierungsschicht mittels einer Hot-Melt-Tinte oder eines Fotolackes mit dem Aufbringen der Metallschicht durch Sputtern kombiniert. Diese Kombination wurde bisher nicht angewandt, da das Aufbringen einer Metallschicht mittels Sputtern einen entscheidenden Nachteil aufweist:
Bei dem Sputtern metallischer oder dielektrischer Schichten wird die Grenzschicht zu dem Halbleitersubstrat aufgrund der prozessbedingt auftretenden, unerwünschten Strahlung im Prozessraum geschädigt. Diese Schädigung ist beispielsweise in DiMaria, D.J., L.M. Ephrath, and D.R. Young, Radiation damage in silicon dioxide films exposed to reactive ion etching. J. Appl. Phys., 1979. 50: p. 4015-4021 beschrieben. Es wurde aus diesem Grund beispielsweise in den in der DE 10 2008 029 107 A1 beschriebenen Verfahren das Aufdampfen der Metallschicht in Verfahrensschritt B vorgeschlagen. Bei anderen Herstellungsverfahren war es bisher notwendig, nach einem Sputterprozess die entstandene Schädigung in einem anschließenden Temperaturschritt durch globales Erhitzen des Halbleitersubstrates ("Tempern") wieder zu kompensieren. Dieser Temperaturschritt führt zum einen zu einer höheren Komplexität des Verfahrens und zu höheren Kosten. Zum anderen kann die Behandlung mittels eines Temperaturschritts negative Auswirkungen auf die Halbleiterstruktur, insbesondere auf Schichten aus amorphem Silizium bei der Herstellung von Solarzellen haben.

Der Erfindung liegt die Erkenntnis der Anmelderin zugrunde, dass überraschenderweise eine mittels Hot-Melt-Tinte erzeugte Strukturierungsschicht und ebenso eine mittels Fotolack erzeugte Strukturierungsschicht die Oberfläche des Halbleitersubstrates vor Schädigungen bei Aufbringen der Metallschicht mittels Sputtern schützt. Diese Erkenntnis ist überraschend, da die Schädigung bei Aufbringen einer Metallschicht mittels Sputtern nach bisherigen Erkenntnissen von einer prozessbedingt auftretenden Strahlung im Prozessraum verursacht wird, für die eine mittels Hot-Melt-Tinte oder mittels Fotolack erzeugte Schicht keine oder nur eine geringe Absorption aufweist. Es wurde daher bisher davon ausgegangen, dass eine mittels Hot-Melt-Tinte oder Fotolack hergestellte Strukturierungsschicht keinerlei Auswirkung auf eine Schädigung beim Sputtern aufweist. Überraschenderweise zeigen Untersuchungen des Anmelders jedoch, dass keine oder nur eine geringfügige Schädigung in den Bereichen der Oberfläche des Halbleitersubstrates auftreten, in denen sich die mittels Hot-Melt-Tinte oder Fotolack erzeugte Strukturierungsschicht zwischen Oberfläche des Halbleitersubstrates und mittels Sputtern aufgebrachter Metallschicht befindet. Versuchsergebnisse hierzu sind in der Figurenbeschreibung beigefügt.

Durch das erfindungsgemäße Verfahren können somit erstmals die Vorteile des Erzeugens einer Strukturierungsschicht mittels Hot-Melt-Tinte oder Fotolack mit den zuvor erwähnten Vorteilen des Aufbringens einer Metallschicht mittels Sputtern kombiniert werden. Weiterhin bestand bisher keine Möglichkeit, bereits beim Sputterprozess die Schädigung der Oberfläche des Halbleitersubstrates zu vermeiden.

Das erfindungsgemäße Verfahren ist insbesondere bei der Herstellung von Solarzellen und hierbei insbesondere bei der Herstellung hocheffizienter Silizium-Solarzellen geeignet. Denn die Herstellung der Metallstrukturen, welche zur elektrischen Kontaktierung der Solarzelle dienen, durch Verwenden des Sputterprozesses zum Aufbringen der Metallschicht weist beispielsweise gegenüber der Herstellung der Metallstrukturen mittels Siebdruck den Vorteil auf, dass wesentlich höhere Aspektverhältnisse (Höhe zu Breite des Kontaktes) möglich sind, so dass aufgrund des höheren Aspektverhältnisses einerseits ein geringer elektrischer Leitungswiderstand und andererseits eine geringe bedeckte Oberfläche und somit eine geringe Abschattung dieser Oberfläche gegenüber einfallender Strahlung erzielt wird.

Weiterhin ist der Kontaktwiderstand bei Aufbringen der Metallschicht mittels Sputtern geringer gegenüber anderen Verfahren wie beispielsweise Aufbringen der Metallschicht mittels Siebdruck.

Diese Vorteile des Aufbringens einer Metallschicht mittels Sputtern können nun aufgrund mittels des erfindungsgemäßen Verfahrens kombiniert werden mit den Vorteilen des Aufbringens der Strukturierungsschicht mittels einer Hot-Melt-Tinte oder mittels Fotolack.

Die Verwendung von Fotolack insbesondere zur Ausbildung einer Strukturierungsschicht ist zur Herstellung einer Metallstruktur auf einer Oberfläche eines Halbleitersubstrates und insbesondere bei der Herstellung von Solarzellen bekannt. Fotolack wird hierbei typischerweise in Verbindung mit einem Fotolithografieprozess verwendet, bei dem der lichtempfindliche Fotolack mittels einer Maske teilweise belichtet und anschließend entwickelt und entfernt wird, so dass die Strukturierungsschicht erzeugt wird. Hierbei liegt die Verwendung von Negativlack sowie von Positivlack und entsprechenden Fotolithografieprozessen im Rahmen der Erfindung.

Besonders vorteilhaft ist die Ausbildung des erfindungsgemäßen Verfahrens bei Erzeugung der Strukturierungsschicht mittels einer Hot-Melt-Tinte, da hierdurch die zuvor beschriebenen Vorteile und insbesondere die Kosteneinsparungen durch Verwendung der Hot-Melt-Tinte erzielt werden.

Vorzugsweise wird vor Verfahrensschritt A eine Isolierungsstruktur auf die Oberfläche der Halbleiterstruktur oder auf ein oder mehrere die Oberfläche bedeckende Zwischenschichten aufgebracht. Die Isolierungsstruktur wird dabei derart aufgebracht, dass sie die Halbleiterstruktur in Teilbereichen nicht bedeckt. Die Isolierungsstruktur dient somit dem Zweck, an den Bereichen der Oberfläche der Halbleiterstruktur, an denen keine Bedeckung durch die Metallstruktur erfolgen soll, eine elektrische Isolierung zu erwirken. Vorzugsweise weist die Isolierungsstruktur darüber hinaus passivierende Eigenschaften auf, welche die Oberflächenrekombinationsgeschwindigkeit von Minoritätsladungsträgern an der Oberfläche des Halbleitersubstrates verringern gegenüber solchen Bereichen, die nicht mit der Isolierungsstruktur bedeckt sind. Vorzugsweise ist die Isolierungsschicht aus Siliziumdioxid oder Siliziumnitrid ausgebildet.

In dieser vorzugsweisen Ausführungsform wird die Strukturierungsschicht von dem Halbleitersubstrat als untere Basis ausgehend über der Isolierungsstruktur aufgebracht. Ein anschließendes Aufbringen der Metallschicht mittels Sputtern führt somit dazu, dass in den Bereichen der Oberfläche des Halbleitersubstrates, die durch die Isolierungsschicht bedeckt sind und demgemäß insbesondere eine geringe Oberflächenrekombinationsgeschwindigkeit aufweisen sollen, ein Schutz gegenüber Schädigung während des Sputterprozesses durch die Strukturierungsschicht vorliegt.

Vorzugsweise ist das erfindungsgemäße Verfahren daher derart ausgebildet, dass in Verfahrensschritt A die Strukturierungsschicht ausschließlich auf die Isolierungsstruktur aufgebracht wird, im Weiteren vorzugsweise, dass die Isolierungsschicht und die Strukturierungsschicht mit zumindest teilweise übereinander liegenden Begrenzungen aufgebracht werden, insbesondere, dass die Strukturierungsschicht die Isolierungsschicht vollständig bedeckend aufgebracht wird.

Wie zuvor ausgeführt, erfolgt aufgrund der Schutzwirkung der Strukturierungsschicht keine oder nur eine geringfügige Schädigung der Oberfläche des Halbleitersubstrates in den Bereichen unterhalb der Strukturierungsschicht bei dem Sputterprozess. Aus diesem Grund kann auf bisher notwendige nachfolgende Temperaturschritte zum Ausheilen etwaiger Schäden aufgrund des Sputterprozesses verzichtet werden.

Vorzugsweise ist das erfindungsgemäße Verfahren daher derart ausgeführt,
dass nach Durchführen des Verfahrensschrittes A keine globale Erwärmung des Halbleitersubstrates auf mehr als 200 °C, vorzugsweise auf mehr als 100 °C, im weiteren bevorzugt auf mehr als 50 °C erfolgt. Hierdurch wird die Belastung des Halbleitersubstrates und etwaiger aufgebrachter Schichten verringert. Insbesondere ist eine Schädigung beispielsweise von Schichten aus amorphem Silizium aufgrund globaler Erwärmung über die genannten Temperaturwerte ausgeschlossen.

Vorteilhafterweise weist die Strukturierungsschicht Ausnehmungen auf, welche die Bereiche definieren, an denen die Metallstruktur auf der Oberfläche des Halbleitersubstrates erzeugt werden soll. Ebenso liegt es im Rahmen der Erfindung, dass die Strukturierungsschicht aus mehreren nebeneinander liegenden Strukturierungseinzelschichten besteht oder dass eine Kombination von Strukturierungseinzelschichten und Ausnehmungen vorliegt.

Vorteilhafterweise wird in Schritt A die Hot-Melt-Tinte mittels einer Druckdüse aufgebracht. Hierdurch können im Vergleich mit einem Siebdruckverfahren feinere Strukturen erzeugt werden. Insbesondere ist es vorteilhaft, dass die Druckdüse zum Auftragen der Hot-Melt-Tinte in etwa parallel zur Oberfläche des Halbleitersubstrates bewegt wird. Ebenso liegt die kinematische Umkehr im Rahmen der Erfindung, d. h. dass das Halbleitersubstrat in etwa parallel zur Druckdüse bewegt wird oder eine Kombination der Bewegung von Druckdüse und Halbleitersubstrat.

Diese Aufbringungsmethode der Hot-Melt-Tinte mittels einer Druckdüse weist den Vorteil auf, dass durch Wahl einer entsprechend feinen Druckdüse feine Strukturen herstellbar sind. Weiterhin ergaben Untersuchungen des Anmelders, dass insbesondere die Oberfläche von Halbleitersubstraten zur Herstellung von Solarzellen Unebenheiten aufweisen können, sodass bei Verwendung eines Siebdruckverfahrens das Sieb teilweise nicht vollständig auf der Oberfläche des Halbleitersubstrates aufliegt und daher vermehrt fehlerhafte Strukturen erzeugt werden. Durch das Aufbringen der Hot-Melt-Tinte mittels einer Druckdüse werden eventuelle Unebenheiten der Oberfläche des Halbleitersubstrates ausgeglichen, ohne dass eine Verfälschung der vorgegebenen Struktur erfolgt.

Vorteilhafterweise erfolgt das Aufbringen der Hot-Melt-Tinte kontaktlos. Insbesondere ist es vorteilhaft, dass die Hot-Melt-Tinte, wie zuvor beschrieben, mittels einer Druckdüse aufgebracht wird und sich die Druckdüse in einem Abstand von mindestens 100 µm von der Oberfläche des Halbleitersubstrates befindet.

In einer weiteren vorteilhaften Ausgestaltung wird die Hot-Melt-Tinte in Schritt A mittels eines an sich bekannten Inkjet-Druckverfahrens aufgebracht. Das Inkjet-Druckverfahren findet insbesondere bei Tintenstrahldruckern eine breite Verwendung. Eine Übersicht über die Technik der Inkjet-Druckverfahren findet sich in J.Heinzl, C.H.Hertz, "inkjet printing", advances in electronics and electron physics, vol. 65 (1985), pp. 91-112.

Bei dem erfindungsgemäßen Verfahren kann somit auf die bereits bekannte Technik der Inkjet-Druckverfahren zurückgegriffen werden, um eine Metallstruktur auf einer Oberfläche eines Halbleitersubstrates zu erzeugen.

Die Dicke der Strukturierungsschicht liegt vorteilhafterweise im Bereich von etwa 20 µm bis 35 µm.

Vorzugsweise werden bei dem bereits beschriebenen Sputterprozess die Prozessparamter derart gewählt, dass eine negative Beeinflussung der Eigenschaften der Hot-Melt-Tinte, wie beispielsweise eine Verflüssigung, verhindert wird. Insbesondere wird der Sputterprozess vorzugsweise derart ausgeführt, dass die Strukturierungsschicht nicht über den Schmelzpunkt der verwendeten Hot-Melt-Tinte erwärmt wird, vorzugsweise nicht über 80°C, bevorzugt nicht über 50°C, um ein Aufschmelzen der Strukturierungsschicht während des Sputterprozesses zu verhindern.

In einer weiteren vorteilhaften Ausgestaltung des erfindungsgemäßen Verfahrens wird in Schritt B die Metallschicht derart aufgebracht, dass sie die Oberfläche des Halbleitersubstrates bzw. der Strukturierungsschicht im Wesentlichen vollständig bedeckt.

Im Rahmen dieser Anmeldung bezeichnet der Begriff "Oberfläche des Halbleitersubstrates" diejenige Oberfläche, auf die die gewünschte Metallstruktur aufgebracht wird. Dies kann unmittelbar die Oberfläche des Halbleiters sein, ebenso kann das Halbleitersubstrat jedoch auch aus einer Schichtstruktur bestehen, wobei auf die oberste Schicht dieser Struktur (beispielsweise eine elektrisch isolierende Schicht) die Metallstruktur aufgetragen werden soll. In diesem Fall bezeichnet "Oberfläche des Halbleitersubstrates" somit die Oberfläche der obersten Schicht der Halbleiterstruktur.

Das erfindungsgemäße Verfahren eignet sich insbesondere zur Erzeugung einer Metallstruktur zur Kontaktierung einer Halbleitersolarzelle. Vorteilhafterweise ist die Metallstruktur daher eine Kontaktierungsstruktur für eine HalbleiterSolarzelle, wobei die Solarzelle mittels des Halbleitersubstrates ausgebildet wird.

In einer vorteilhaften Ausgestaltung des erfindungsgemäßen Verfahrens wird eine UV-härtende Hot-Melt-Tinte verwendet. Diese weist die Eigenschaft auf, dass sie durch Einwirkung von US-Strahlung gehärtet wird, so dass auch bei einer nachfolgenden Temperatureinwirkung keine Verflüssigung mehr erfolgt.

Vorteilhafterweise wird daher bei dem erfindungsgemäßen Verfahren die Strukturierungsschicht in Schritt A mittels einer UV-härtenden Hot-Melt-Tinte erzeugt. Insbesondere ist es vorteilhaft, nach Schritt B, d. h. nach Aufbringen der Strukturierungsschicht, diese mit UV-Strahlung zu bestrahlen, so dass die gewünschte Härtung der Strukturierungsschicht erfolgt.

Typische UV-härtende Hot-Melt-Tinten werden durch Bestrahlung im Wellenlängenbereich von 200 nm bis 450 nm gehärtet, wobei vorzugsweise eine Energiemenge von 100 mJ bis 500 mJ zur Härtung in die Hot-Melt-Tinte eingebracht wird. Als Bestrahlungsquelle ist die Verwendung einer Quecksilberdampflampe vorteilhaft.

Weitere Merkmale und vorteilhafte Ausgestaltungen des erfindungsgemäßen Verfahrens werden im Folgenden anhand der Figuren beschrieben. Dabei zeigt:
- Figur 1: Lebensdauermessungen an Proben zum Nachweis des Schutzes einer mittels Hot-Melt-Tinte erzeugten Schicht gegenüber Schädigung durch den Sputterprozess;
- Figur 2a: Verfahrensschritte A0 und A eines ersten Ausführungsbeispiels des erfindungsgemäßen Verfahrens;
- Figur 2b: Verfahrensschritte B, B1 und C des ersten Ausführungsbeispiels des erfindungsgemäßen Verfahrens und
- Figur 3: Verfahrensschritte A0, A und A1 eines zweiten Ausführungsbeispiels des erfindungsgemäßen Verfahrens.

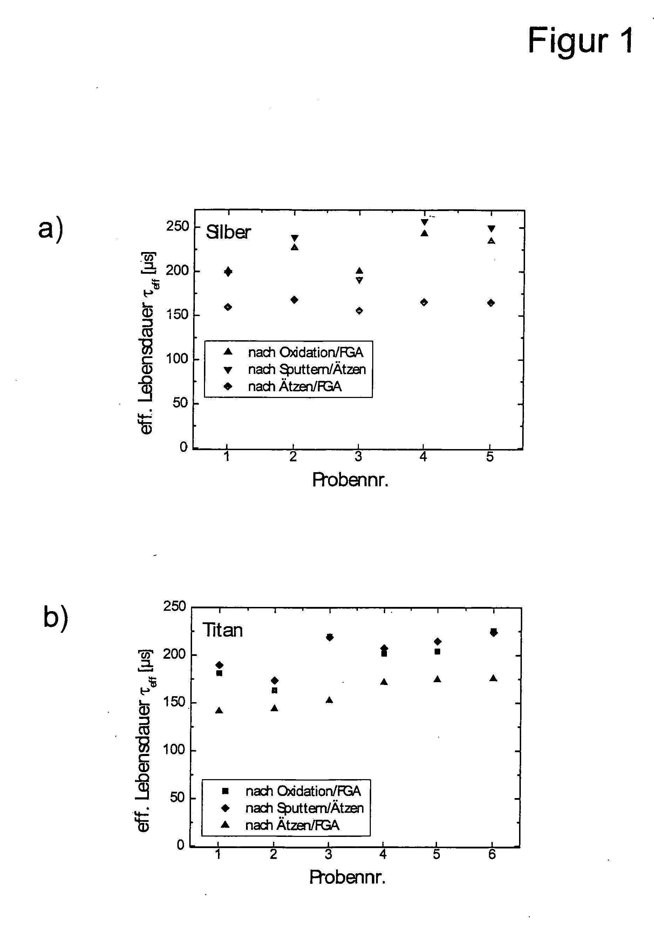

Figur 1 zeigt Messungen der effektiven Lebensdauer an verschiedenen Proben. Bei den Proben handelt es sich um monokristalline Siliziumwafer mit einer p-Basisdotierung von 1 Ω*cm, die beidseitig mit einer 100 nm dicken Siliziumoxidschicht versehen und anschließend auf beiden Seiten vollflächig mit einer Schicht aus Hot-Melt-Tinte geschützt wurden. Die Proben wurden bei verschiedenen Prozessstadien vermessen: Die erste Messung der effektiven Lebensdauer der Minoritätsladungsträger mit Hilfe der QSSPC-Methode (QSSPC = Quasi steady state photoconductance) wurde nach dem Abscheiden der Siliziumoxidschicht und anschließendem Behandeln dieser Schicht mittels eines Temperaturschrittes ("Tempern") durchgeführt; die zweite Messung erfolgte nach dem ganzflächigen Aufbringen zunächst einer Schicht aus Hot-Melt-Tinte und anschließend einer Metallschicht mittels Sputtern und die dritte Messung erfolgte nach einem weiteren Temperaturschritt ("Tempern") unter Formiergasatmosphäre.

Hierbei sind in Figur 1a die Ergebnisse für Titan als verwendetes Metall beim Sputtern und in Figur.1b für Silber als verwendetes Metall beim Sputtern dargestellt. Die Ergebnisse zeigen, dass unabhängig von dem verwendeten Metall die effektive Lebensdauer der Minoritätsladungsträger bei den durch die Schicht aus Hot-Melt-Tinte geschützten Proben gleich blieb. Bei Vergleichsproben, bei denen kein Schutz durch eine mittels Hot-Melt-Tinte hergestellte Schicht vorlag, ergab die Lebensdauermessung sehr geringe Lebensdauern (kleiner 5 µs).

Vergleichbare Ergebnisse zeigten sich bei einer analogen Versuchsdurchführung, bei der statt einer Schicht aus Hot-Melt-Tinte eine Schicht aus Fotolithografielack ganzflächig aufgebracht wurde.

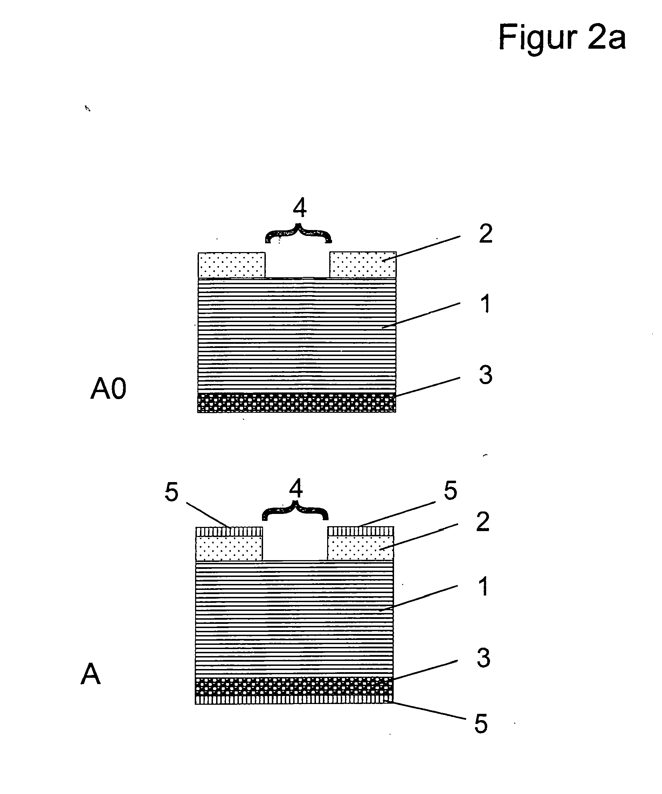

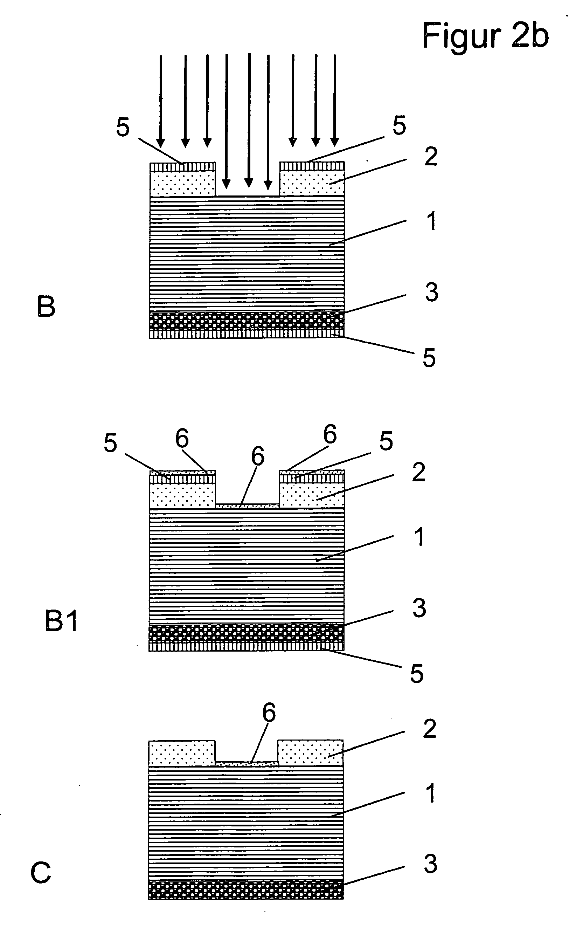

Figuren 2a und 2b zeigen ein erstes Ausführungsbeispiel des erfindungsgemäßen Verfahrens zur Herstellung der metallischen Kontaktierungsstruktur auf der Vorderseite einer Halbleitersolarzelle.

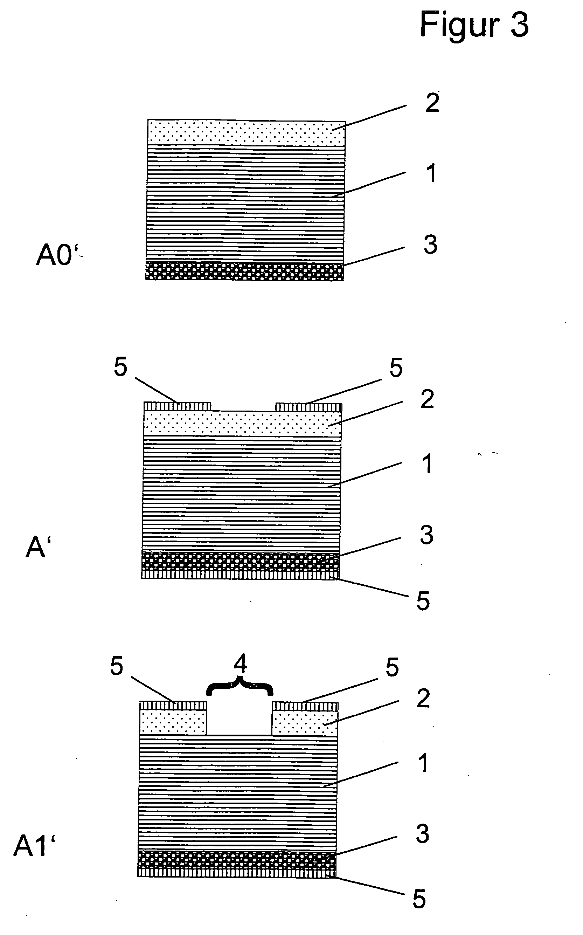

Die schematischen Darstellungen in den Figuren 2, 2a und 3 zeigen jeweils einen Teilausschnitt senkrecht zur Vorderseite des Halbleitersubstrates. Hierbei ist lediglich der Teilausschnitt eines mit einer Metallisierung zu versehenden Kontaktierungsbereiches dargestellt. Die Solarzelle weist eine Vielzahl solcher Kontaktierungsbereiche auf und setzt sich in der schematischen Darstellung gemäß Figur 2 jeweils nach rechts und links fort.

Das erste Ausführungsbeispiel des erfindungsgemäßen Verfahrens gemäß den Figuren 2a und 2b umfasst folgende Verfahrensschritte:
Die Solarzelle wird aus einem Halbleitersubstrat 1 hergestellt, welches eine p-Basisdotierung von 1 Ω*cm aufweist. In einem Verfahrensschritt A0 wurde auf der Vorderseite des Halbleiersubstrates 1 eine Isolierungsstruktur 2 und auf der Rückseite des Halbleitersubstrates 1 eine Rückseitenpassivierungsschicht 3 aufgebracht. Sowohl die Isolierungsstruktur 2, als auch die Rückseitenpassivierungsschicht 3 dienen zur elektrischen Passivierung der jeweils bedeckten Oberfläche des Halbleitersubstrates 1 und zur Passivierung, d. h. Verringerung der Rekombinationsgeschwindigkeit der Minoritätsladungsträger an den bedeckten Oberflächen. Die Isolierungsstruktur 2 ist auf der bei späterem Betrieb der Einstrahlung zugewandten Vorderseite der herzustellenden Solarzelle aufgebracht und daher zusätzlich als Antireflexschicht (Antireflectioncoating, ARC) ausgebildet. Die Isolierungsstruktur 2 ist als Siliziumdioxidschicht mit einer Dicke von etwa 100 nm ausgebildet. Die Rückseitenpassivierungsschicht ist als Siliziumdioxidschicht mit einer Dicke von ebenfalls etwa 100 nm ausgebildet.

Auf der Rückseitenpassivierungsschicht 3 ist (nicht dargestellt) bereits eine ganzflächig die Rückseitenpassivierungsschicht 3 bedeckende Rückseitenmetallisierungsschicht aufgebracht, welche als Aluminiumschicht ausgebildet ist. Diese Aluminiumschicht durchgreift punktweise die Rückseitenpassivierungsschicht 3, so dass eine elektrisch leitende Verbindung zwischen Halbleiterstruktur 1 und der Rückseitenkontaktierungsschicht ausgebildet ist.

Die Isolierungsstruktur 2 weist Aussparungen an einem Kontaktierungsbereich 4 der Vorderseite des Halbleitersubstrates 1 auf, d. h. eine Aussparung in demjenigen Bereich, in dem eine Kontaktierung des Halbleitersubstrates 1 durch eine Metallstruktur, welche die Vorderseitenkontaktierung der herzustellenden Solarzelle bildet, erzeugt werden soll. Solche Metallstrukturen zur Kontaktierung der Vorderseite einer Solarzelle sind typischerweise mit linienartigen Elementen ausgebildet und weisen insgesamt typischerweise kammartige Strukturen auf. Die Darstellungen in Figur 2 sind Teilausschnitte quer zur Oberfläche des Halbleitersubstrates 1 und quer zu dem linienartigen Verlauf solch einer Metallstruktur. Die Breite des Kontaktierungsbereiches 4 beträgt etwa 30 µm.

Das Halbleitersubstrat 1 weist weiterhin an der Vorderseite eine (nicht dargestellte) n-Dotierung in dem Halbleitersubstrat mit einer Tiefe zwischen 0,5 µm bis 1 µm auf, so dass sich im Grenzbereich zwischen n- und p-Dotierung ein pn-Übergang ausbildet.

In einem Verfahrensschritt A des Ausführungsbeispiels des erfindungsgemäßen Verfahrens wird eine Strukturierungsschicht 5 auf die Isolierungsstruktur 2 aufgebracht. Die Strukturierungsschicht 5 bedeckt dabei die Isolierungsstruktur 2 vollständig, weist jedoch ebenfalls Aussparungen an den Kontaktierungsbereichen 4 auf. Die Strukturierungsschicht 5 ist aus Hot-Melt-Tinte im Inkjet-Druckverfahren hergestellt. Um die Rückseite vor weiteren Einflüssen zu schützen, wurde auf der Rückseitenpassivierungsschicht 3 bzw. der diese Schicht bedeckenden Metallisierungsschicht ganzflächig ebenfalls die Strukturierungsschicht aus Hot-Melt-Tinte aufgebracht.

In einem Verfahrensschritt B erfolgt ein ganzflächiges Aufbringen einer Metallschicht 6 auf die Vorderseite. Das Aufbringen erfolgt mittels Sputterdeposition und ist in Figur 2B durch Pfeile angedeutet. Das Ergebnis ist in Figur 2 B1 dargestellt. Die Metallschicht 6 bedeckt somit sowohl die Strukturierungsschicht 5, als auch den ausgesparten Kontaktierungsbereich 4 der Oberfläche des Halbleitersubstrates 1.

Die Metallschicht 6 ist vorzugsweise als Zweischichtsystem (beispielsweise Titan und Silber) ausgebildet, mit einer Dicke von etwa 30 nm der ersten Schicht und 50 nm der zweiten Schicht. Ersatzweise kann die Metallschicht aus Kombinationen von Nickel-Vanadium und Silber, Aluminium und Silber, Nickel-Chrom und Silber, Titan und Titannitrid, Titannitrid und Silber oder einem Dreischichtsystem aus Titan, Titannitrid und Silber bestehen.

Wesentlich ist, dass bei dem Aufbringen der Metallschicht 6 in Verfahrensschritt B ein Schutz der Oberfläche des Halbleitersubstrates 1 durch die Strukturierungsschicht 5 erfolgt, d. h. eine Schädigung erfolgt lediglich in dem Kontaktierungsbereich 4 der Oberfläche des Halbleitersubstrates 1. Dieses Unterbinden der Oberflächenschädigung ist überraschenderweise auf die Schutzwirkung der aus Hot-Melt-Tinte ausgebildeten Strukturierungsschicht 5 gegenüber der beim Sputterprozess im Prozessraum auftretenden Strahlung zurückzuführen.

Die an die Isolierungsstruktur 2 angrenzende Oberfläche des Halbleitersubstrates 1 weist somit eine durch den Sputterprozess ungeschädigte Oberfläche und damit weiterhin geringe Oberflächenrekombinationsgeschwindigkeit auf. Die Schädigung der Oberfläche im Kontaktierungsbereich 4 ist irrelevant, da an den durch die Metallisierung bedeckten Bereichen auch ohne Schädigung im Sputterprozess hohe Rekombinationsraten auftreten. Im Prozessstadium gemäß Figur 2 B1 ist somit eine Metallisierung erfolgt, ohne dass eine Schädigung der nicht metallisierten Bereiche der Oberfläche damit einherging, so dass insbesondere ein späteres "Ausheilen" etwaiger Schädigungen durch einen Hochtemperaturschritt nicht notwendig ist.

In einem Verfahrensschritt C gemäß Figur 2C wird die Strukturierungsschicht wie folgt wieder abgelöst: in einem Lift-Off-Verfahren wieder abgelöst. Hierzu wird das metallisierte und mit der Strukturierungsschicht versehene Halbleitermaterial in einem Becken mit Aceton und anschließend IPA (Isopropanol-Alkohol) behandelt. Hierdurch wird die Metallschicht in den nicht durch Isolierungsstruktur 2 und Strukturierungsschicht 5 ausgesparten Bereichen wieder abgelöst, ebenfalls die lediglich zum Schutz während des Verfahrensprozesses aufgebrachte Strukturierungsschicht 5 auf der Rückseite.

Das zweite Ausführungsbeispiel des erfindungsgemäßen Verfahrens umfasst die Verfahrensschritte A0, A und A1 gemäß Figur 3 sowie die bereits zuvor beschriebenen Verfahrensschritte B, B1 und C gemäß Figur 2b.

Bei diesem zweiten Ausführungsbeispiel bezeichnen die Bezugszeichen gleiche Elemente wie auch bereits zu den Figuren 2a und 2b beschrieben. Auch der Verfahrensablauf ist grundsätzlich gleich, lediglich die Aussparungen an dem Kontaktierungsbereich 4 werden auf andere Weise erzeugt:
In einem Verfahrensschritt A0' wird auf der Vorderseite des Halbleitersubstrates 1 eine Isolierungsstruktur 2 und auf der Rückseite des Halbleitersubstrates 1 eine Rückseitenpassivierungsschicht 3 aufgebracht. Diese sind gemäß der Beschreibung zu Figur 2a ausgebildet. Ebenso ist auf der Rückseitenpassivierungsschicht 3 (nicht dargestellt) bereits eine ganzflächig die Rückseitenpassivierungsschicht 3 bedeckende Rückseitenmetallisierungsschicht aufgebracht, welche als Aluminiumschicht ausgebildet ist und punktweise die Rückseitenpassivierungsschicht 3 durchgreift.

In einem Verfahrensschritt A' wird die Strukturierungsschicht 5 auf die Isolierungsstruktur 2 aufgebracht. Die Strukturierungsschicht 5 weist dabei Aussparungen an den Kontaktierungsbereichen 4 auf und ist aus Hot-Melt-Tinte im Inkjet-Druckverfahren hergestellt. Wie auch zu Figur 2a beschrieben, wird in Verfahrensschritt A weiterhin auf der Rückseitenpassivierungsschicht 3 bzw. der diese Schicht bedeckenden Metallisierungsschicht ganzflächig ebenfalls eine Schicht aus Hot-Melt-Tinte aufgebracht, um die Rückseite vor weiteren Einflüssen zu schützen.

In einem Verfahrensschritt A1' erfolgt ein Entfernen der Isolierungsstruktur 2 an den Kontaktierungsbereichen, d. h. an den Bereichen, an denen die Isolierungsstruktur 2 nicht durch die Strukturierungsschicht 5 bedeckt ist.

In diesem zweiten Ausführungsbeispiel dient somit die Strukturierungsschicht 5 ebenso als Maske zur Erzeugung der Ausnehmungen an den Kontaktierungsbereichen 4 in der Isolierungsstruktur 2.

Die weiteren Verfahrensschritte B, B1 und C erfolgen wie zu Figur 2b beschrieben.

## Patentansprüche

1. Verfahren zur Herstellung einer Metallstruktur auf einer Oberfläche eines Halbleitersubstrates,
folgende Schritte umfassend:
A Aufbringen einer Strukturierungsschicht (5), welche mittels einer Hot-
Melt-Tinte oder eines Fotolackes erzeugt wird, auf die Oberfläche der Halbeiterstruktur oder auf eine oder mehrere die Oberfläche bedeckenden Zwischenschichten, wobei die Strukturierungsschicht in den Bereichen der Oberfläche des Halbleitersubstrates aufgebracht wird, in denen keine Metallstruktur erwünscht ist.
B Aufbringen einer Metallschicht (6) und
C Entfernen der Strukturierungsschicht (5),
wobei
in einem Lift-Off-Verfahren Schritt B nach Schritt A und Schritt C nach Schritt B ausgeführt wird, derart, dass die Strukturierungsschicht (5) im Wesentlichen von der Metallschicht (6) bedeckt ist und zumindest in den Bereichen, in denen die Metallschicht (6) die Strukturierungsschicht (5) bedeckt, bei Ausführung von Schritt C die Metallschicht (6) abgelöst wird,
**dadurch gekennzeichnet,**
**dass** in Schritt B die Metallschicht (6) mittels Sputterdeposition ("Sputtern") aufgebracht wird.

2. Verfahren nach Anspruch 1,
**dadurch gekennzeichnet,**
**dass** vor Verfahrensschritt A eine Isolierungsstruktur auf die Oberfläche der Halbleiterstruktur oder auf eine oder mehrere die Oberfläche bedeckende Zwischenschichten aufgebracht wird, wobei die Isolierungsstruktur die Halbleiterstruktur in Teilbereichen nicht bedeckend aufgebracht wird.

3. Verfahren nach Anspruch 2,
**dadurch gekennzeichnet,**
**dass** in Verfahrenschritt A die Strukturierungsschicht (5) ausschließlich auf die Isolierungsstruktur aufgebracht wird.

4. Verfahren nach einem der Ansprüche 2 bis 3,
**dadurch gekennzeichnet,**
**dass** Isolierungsschicht und Strukturierungsschicht (5) mit zumindest teilweise übereinanderliegenden Begrenzungen aufgebracht werden.

5. Verfahren nach einem der vorangegangenen Ansprüche,
**dadurch gekennzeichnet,**
**dass** nach Durchführen des Verfahrensschrittes A keine globale Erwärmung des Halbleitersubstrates auf mehr als 200°C, vorzugsweise auf mehr als 100°C, im Weiteren bevorzugt auf mehr als 50°C erfolgt.

6. Verfahren nach einem der vorangegangenen Ansprüche,
**dadurch gekennzeichnet,**
**dass** die Strukturierungsschicht (5) Ausnehmungen aufweist und/oder aus mehreren nebeneinander angeordneten Strukturierungseinzelschichten besteht.

7. Verfahren nach einem der vorangegangenen Ansprüche,
**dadurch gekennzeichnet,**
**dass** in Schritt B die Hot-Melt-Tinte mittels einer Druckdüse aufgebracht wird, insbesondere, dass die Druckdüse zum Auftragen der Hot-Melt-Tinte in etwa parallel zur Oberfläche des Halbleitsubstrates bewegt wird.

8. Verfahren nach einem der vorangegangenen Ansprüche,
**dadurch gekennzeichnet,**
**dass** das Aufbringen der Hot-Melt-Tinte kontaktlos erfolgt, insbesondere, dass die Hot-Melt-Tinte mittels einer Druckdüse aufgebracht wird, welche sich in einem Abstand von mindestens 100 µm von der Oberfläche des Halbleitersubstrates befindet.

9. Verfahren nach einem der vorangegangenen Ansprüche,
**dadurch gekennzeichnet,**
**dass** in Schritt B die Hot-Melt-Tinte mittels eines Inkjet-Druckverfahrens aufgebracht wird.

10. Verfahren nach einem der vorangegangenen Ansprüche,
**dadurch gekennzeichnet,**
**dass** eine Hot-Melt-Tinte verwendet wird, deren Schmelzpunkt im Bereich von 60°C bis 100°C liegt, insbesondere im Bereich von 70°C bis 80°C liegt.

11. Verfahren nach einem der vorangegangenen Ansprüche,
**dadurch gekennzeichnet,**
**dass** in Schritt A die Metallschicht (6) derart aufgebracht wird, dass sie die Oberfläche des Halbleitersubstrates bzw. die Strukturierungsschicht (5) im Wesentlichen vollständig bedeckt.

12. Verfahren nach einem der vorangegangenen Ansprüche,
**dadurch gekennzeichnet,**
**dass** die Metallstruktur eine Kontaktierungsstruktur für eine HalbleiterSolarzelle ist, wobei die Solarzelle mittels des Halbleitersubstrates ausgebildet wird.

13. Verfahren nach einem der vorangegangenen Ansprüche,
**dadurch gekennzeichnet,**
**dass** die Hot-Melt-Tinte ein "hydrocarbon wax" ist.

14. Verfahren nach einem der vorangegangenen Ansprüche,
**dadurch gekennzeichnet,**
**dass** nach Aufbringen der Metallstruktur diese verstärkt wird, insbesondere, dass die Metallstruktur galvanisch (strominduziert) verstärkt wird.

15. Verfahren einem der vorangegangenen Ansprüche,
**dadurch gekennzeichnet,**
**dass** die Hot-Melt Tinte eine UV-härtende Hot-Melt-Tinte ist und
**dass** nach Schritt B die Strukturierungsschicht (5) mit UV-Strahlung bestrahlt wird, zum Aushärten der UV-härtenden Hot-Melt-Tinte.
